# EUROPÄISCHE PATENTSCHRIFT

(11) **EP 1 085 793 B1**
(45) Veröffentlichungstag und Bekanntmachung des Hinweises auf die Patenterteilung: **26.05.2004**
(21) Anmeldenummer: 00118458.9
(22) Anmeldetag: 25.08.2000
(51) Int. Cl.: H05K 5/02, H05K 7/14, H02M 7/00

(54) **Kompakte elektrische Vorrichtung, insbesondere Schaltnetzteil**
Electrical compact device for swich mode power supply
Dispositif électrique et compact pour une alimentation à découpage

(30) Priorität: 14.09.1999 DE 19943873; 07.08.2000 DE 10039110
(43) Veröffentlichungstag der Anmeldung: 21.03.2001
(73) Patentinhaber: Siemens Aktiengesellschaft, 80333 München (DE)
(72) Erfinder: Berberich, Reinhold, 60439 Frankfurt/Main (DE); Schultz, Dietmar, 61348 Bad Homburg (DE)

(56) Entgegenhaltungen:
- US-A- 5 075 821
- US-A- 5 365 403
- US-A- 5 926 373

## Beschreibung

Die Erfindung betrifft eine kompakte elektrische Vorrichtung gemäß dem Oberbegriff der Patentansprüche 1 oder 2.

Zur Spannungsangleichung zwischen verschiedenen elektrischen Netzen eines Kraftfahrzeuges wird ein elektrischer Transformator benötigt, der bei möglichst kleinem Bauvolumen kostengünstig herstellbar ist.

Bekannte Einrichtungen bestehen aus mehreren Einzelkomponenten. Die Elektronikplatine, Leistungshalbleiter mit Kühlkörper, Transformator und Verkabelung sind dabei typische Standardkomponenten, wie sie bei solchen Geräten auftreten. Aufgrund dieser zahlreichen Einzelteile nehmen die Montagekosten zu, was sich insbesondere bei großen Produktionsstückzahlen solcher Geräte kostensteigernd auswirkt. Dabei stellen insbesondere die vielen Einzelverbindungen zwischen den Baugruppen neben der Bewicklung des Transformators einen erheblichen Zeitfaktor dar.

Aus der US-PS 5,926,373 ist ein Schaltnetzteil bekannt, bei welchem ein Transformator, der zwischen einer elektrischen Schaltung und einer, mit einer Bezugsspannung verbindbaren elektrischen Kontaktiereinrichtung angeordnet ist, in derart auf einer Leiterplatte ausgebildet, dass die Windungen des Transformators durch die Leiterbahnen der Leiterplatte gebildet werden, welche von einem aus zwei Halbschalen bestehenden Transformatorkern umschlossen sind, die ebenfalls an der Leiterplatte angeordnet sind.

Der Erfindung liegt somit die Aufgabe zugrunde, eine elektrische Vorrichtung anzugeben, welche eine Reduzierung des Montageaufwands ermöglicht und trotzdem zuverlässig arbeitet.

Erfindungsgemäß wird die Aufgabe durch die Merkmale des Patentanspruchs 1 gelöst

Der Vorteil der Erfindung besteht darin, dass verschiedene elektrische Komponenten zu einer mechanisch verbundenen Einheit zusammengefasst werden, wodurch eine mechanische Stabilität der Vorrichtung erreicht wird. Der Herstellungsaufwand sowie die Herstellungskosten der elektrischen Vorrichtung werden dadurch stark reduziert. Ein solcher Elektronikblock enthält dabei alle notwendigen elektrischen Leiterbahnen, die entweder durch temporäre Abstandshalter oder echte Isolierlagen bzw. Schichten voneinander isoliert gehalten und anschließend mit Kunststoff umspritzt werden. Neben der Reduzierung der Arbeitsschritte wird hiermit eine Verbesserung der elektrischen Eigenschaften hinsichtlich der Isolierung erreicht. Darüber hinaus ist diese Kompaktelektronik stoßfest und besitzt schwingungsreduzierte Eigenschaften, was insbesondere für den Einsatz in Kraftfahrzeugen von Vorteil ist.

Alternativ dazu wird die Aufgabe der Erfindung gemäß den Merkmalen des Patentanspruchs 2 gelöst.

Auch bei dieser Anordnung sind die Einzelkomponenten Stecker, Stromzuführung/Verteilung sowie die Transformatorwicklungen bzw. der Transformatorkern in einer kompakten Baueinheit zusammen angeordnet und weisen die bereits erläuterten Vorteile auf.

In einer Ausgestaltung ist zur Bildung der zweiten elektrisch leitenden Verbindung mindestens ein Kontaktstift auf dem Trägerelement zur Verbindung der elektrischen Schaltung mit wenigstens einer Leiterbahn des Trägerkörpers angeordnet, welcher in eine mit der wenigstens einen Leiterbahn elektrisch verbundenen Öffnung hineinragt.

Durch diese Anordnung des starren Stiftes wird die elektrische Verbindung zwischen der elektrischen Schaltung und den elektrisch leitenden Teilen des Trägerkörpers einfach durch Aufstecken des Trägerkörpers auf den Kontaktstift realisiert, wodurch gleichzeitig eine mechanische Arretierung erreicht wird.

Diese elektrische Verbindung läßt sich besonders einfach herstellen, wenn der Kontaktstift zur Herstellung der elektrischen Verbindung in die Öffnung des Trägerkörpers eingepresst ist. Somit läßt sich nicht nur eine elektrische, sondern auch eine dauerhafte mechanische Verbindung erzeugen, welche gegenüber Erschütterungen unempfindlich ist.

In einer anderen Ausführung sind die Enden der als Leiterbahn ausgebildeten ersten elektrischen Verbindung aus der Öffnung des Trägerkörpers diesen überragend hinausgeführt, und gemeinsam mit dem durch die Öffnung hindurchgeführten Kontaktstift verlötet. Sind auf dem Trägerkörper gleichzeitig separate elektrische Bauteile wie ELKO's oder Drosselspulen angeordnet, so können sie in einem Lötvorgang mit der Verlötung des Kontaktstiftes an dem Trägerkörper befestigt werden. Dies gilt auch für zusätzliche Schaltungsplatinen mit bedrahteten Bauelementen, die ebenfalls in dem selben Lötvorgang montiert werden können.

Die Leiterbahnen lassen sich besonders einfach herstellen, wenn sie als Blechformteile ausgebildet sind. Mit Hilfe solcher übereinander geschichteter Stanzbiegebleche, welche die elektrischen Leiterbahnen im Trägerkörper bilden, läßt sich der Trägerkörper einfach als Spritzgußteil herstellen.

Vorteilhafterweise sind die vorzugsweise abgewinkelten Enden der Blechformteile aus dem Trägerkörper zur Bildung der elektrischen Anschlüsse der Steckereinrichtung herausgeführt. Der Körper der Kontaktiereinrichtung ist dabei durch den Trägerkörper gebildet.

In einer Weiterbildung der Erfindung ist der Trägerkörper zur nachträglichen Aufnahme von weiteren elektrischen und/oder elektronischen Komponenten ausgebildet. Insbesondere weist er eine mit Rasteinrichtungen versehene Aufnahme für eine weitere Komponente auf.

So können auf der Außenseite des Trägerkörpers vorteilhaft gehäuste oder ungehäuste elektronische Bauelemente angeordnet werden.

Im selben Kunststoffspritzvorgang lässt sich der Kompaktelektrikblock derart gestalten, dass der Trägerkörper Bestandteil eines Gehäuses ist, welches die elektrische Schaltung des tragenden Trägerelements abdeckt.

Dabei weist der Trägerkörper einen umlaufenden, abgewinkelten Kragen auf, welcher auf dem Trägerelement aufliegt, wobei an dem Kragen eine ebenfalls umlaufende Dichtung angespritzt ist.

In einer anderen Ausgestaltung ist der Trägerkörper als Gehäusemittelteil mit einer einseitig angespritzten Dichtung zur Auflage auf dem Trägerelement ausgebildet, wobei das Gehäusemittelteil mit einer planen Abdeckung verschlossen ist, die ebenfalls eine angespritzte Dichtung aufweist, die auf dem Gehäusemittelteil aufliegt.

Zur Abführung der Verlustwärme ist das Trägerelement aus Metall, vorzugsweise Aluminium hergestellt und dient gleichzeitig zur Wärmeableitung für die Leistungsbauelemente.

Zur Verbesserung der thermischen Eigenschaften ist bei einer Weiterbildung der Erfindung vorgesehen, dass das Trägerelement ein Substrat trägt, welches aus auf wärmeleitende Keramik aufgebrachtem Kupfer (Direct Copper Bonding) besteht.
Durch die sehr gute Wärmeleitung dieses Materials werden hohe Leistungen der Leistungstransistoren ermöglicht.

Durch die Auflage des ersten Kernelementes auf dem als Kühlkörper ausgebildeten Trägerelement ist der Transformator mit hoher Leistung betreibbar und kann einen hohen Wirkungsgrad aufweisen. Der Transformator arbeitet dabei zuverlässig bei denen in modernen Kraftfahrzeugen auftretenden hohen Strömen und ist problemlos kühlbar.

In einer weiteren Ausgestaltung ragen die Primär- und Sekundärwicklungen des Transformators seitlich unterbrochen aus dem Trägerkörper heraus, wobei der einen achtähnlichen Querschnitt aufweisende, einteilige Transformatorkern über die unterbrochenen Primär- und Sekundärwicklungen geschoben wird, wobei nach Aufschieben des Transformatorkerns die Primär- und Sekundärwicklung mittels Schweißen oder Löten elektrisch geschlossen werden.

In einer besonders einfachen Ausgestaltung werden mittels eines aufsteckbaren Trägerkörperabschlussteiles, welches den Wicklungen angepasste Leiterbahnen enthält, die Primär- und Sekundärwicklung elektrisch geschlossen.

Die Primär- und Sekundärwicklung des Transformators sind dabei parallel zu dem ebenen Trägerelement angeordnet.

Die Erfindung lässt zahlreiche Ausführungsformen zu. Eine davon soll anhand der in den Figuren dargestellten Zeichnung näher erläutert werden.

Es zeigt:
- Figur 1: erste Ausführungsform der erfindungsgemäßen Lösung
- Figur 2: zweite Ausführungsform der erfindungsgemäßen Lösung
- Figur 3: Ausgestaltung des Transformatorkerns
- Figur 4: Abschlußteil für die erfindungsgemäße Ausführung gemäß Figur 2
- Figur 5: dritte Ausführung der erfindungsgemäßen Lösung
- Figur 6: vierte Ausführungsform der erfindungsgemäßen Lösung
- Figur 7: erste Abdichtung der elektrischen Vorrichtung
- Figur 8: zweite Abdichtung der elektrischen Vorrichtung

Gleiche Merkmale sind mit gleichen Bezugszeichen gekennzeichnet.

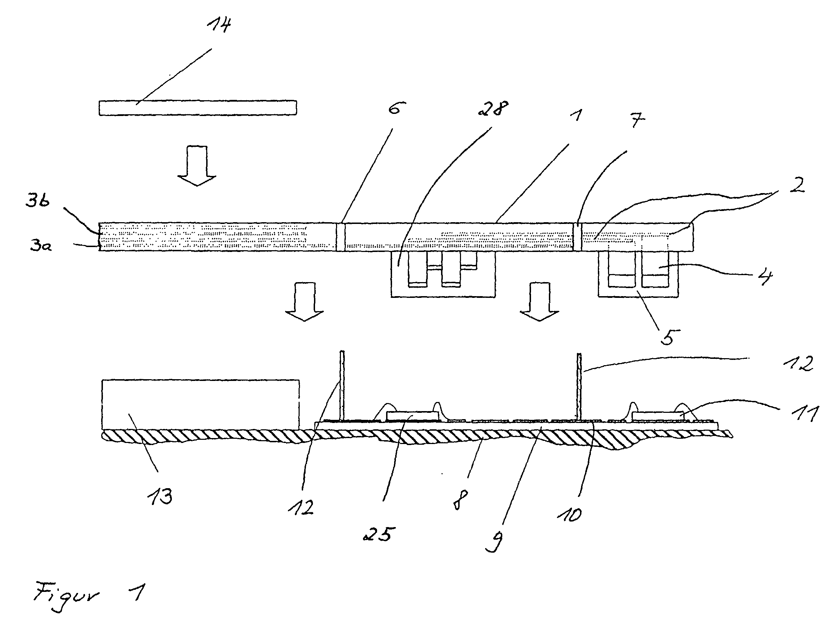

In Figur 1 ist ein Schaltnetzteil dargestellt, wie es zur Anpassung von unterschiedlichen Spannungsniveaus in zahlreichen elektrischen Einrichtungen Einsatz findet. Ein aus Kunststoff hergestellter Trägerkörper 1 beinhaltet mehrere übereinander geschichtete Leiterbahnen 2, die als Stanzbiegebleche ausgebildet sind. Dabei sind die Leiterbahnen 2 so innerhalb des Kunststoffträgerkörpers 1 angeordnet, daß der Kunststoff zwischen den Leiterbahnen 2 isolierend wirkt. Darüber hinaus enthält der Trägerkörper 1 Wicklungen 3a, 3b, die eine Primär- und eine Sekundärwicklung eines Planartransformators bilden. Dabei wird die Primär- 3a und die Sekundärwicklung 3b von mindestens einer Windung gebildet.

Einige Leiterbahnen 2 sind gebogen aus dem Kunststoffträgerkörper 1 herausgeführt, wobei deren Enden Steckerpins 4 bilden und der Kunststoffträgerkörper 1 gleichzeitig durch eine in einem Spritzgußverfahren vorgenommene Ausformung den Steckerkörper 5 bildet.
Darüber hinaus weist der Kunststoffkörper 1 metallisierte und mit den Leiterbahnen 2 verbundene Kontaktöffnungen 6 und 7 auf, in welche Kontaktstifte 12 eingreifen, die auf einem Aluminiumträgerelement 8 angeordnet sind. Auf dem Trägerelement 8 sind eine Keramikleiterplatte 9 befestigt, welche Kupferbahnen 10 aufweist. Die Keramikleiterplatte 9 ist dabei beispielsweise auf den Aluminiumkörper 8 aufgeklebt. Die Kupferbahnen 10 stellen eine elektrische Verbindung zwischen den ebenfalls auf der Leiterplatte 9 angeordneten Leistungsbauelementen 11 und dem Kontaktstift 12 dar. Weiterhin ist auf dem Aluminiumträgerelement 8 das Unterteil 13 eines Planartransformators angeordnet.

Bei der Montage dieses zweiteiligen, aus dem Kunststoffträgerkörper 1 und der Aluminiumträgerplatte 8 bestehenden Schaltnetzteiles, werden die Steckerstifte 12 der Aluminiumplatte 8 in die Kontaktöffnungen 6 bzw. 7 des Trägerkörpers 1 eingeführt. Dies erfolgt in einem Einpressvorgang, das heißt, der Durchmesser der Kontaktöffnungen 6 und 7 ist geringer als die Stärke der Kontaktstifte 12, so daß nach dem Einpressen der Kontaktstifte eine sowohl sichere mechanische als auch elektrische Verbindung des Kontaktstiftes 12 mit den Wicklungen 3 der Primär- und Sekundärspule des Transformators als auch mit den Leiterbahnen 2 gegeben ist.

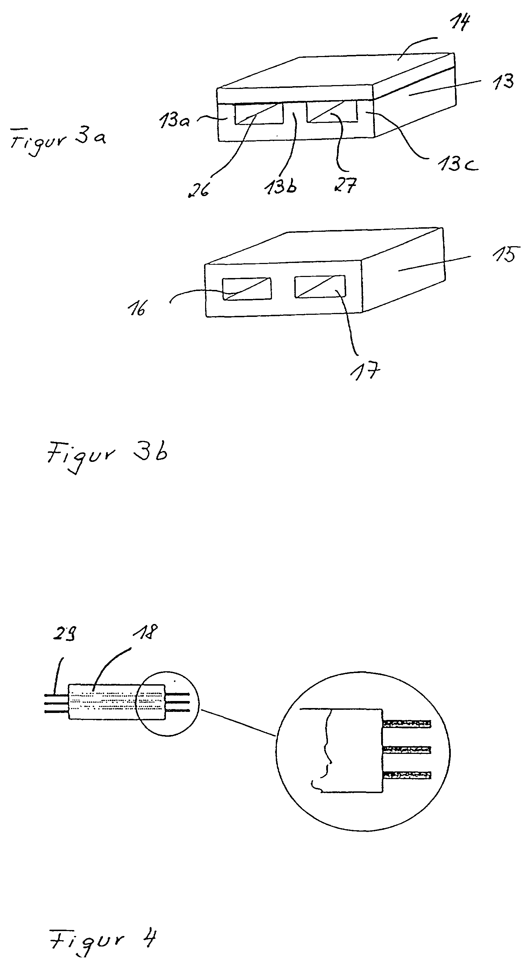

Bei diesem Montagevorgang werden die Wicklungen 3a, 3b in das nach oben offene Unterteil 13 des Transformatorkerns eingeführt. Das Unterteil 13 weist dabei drei in Richtung des Kunststoffkörpers 1 weisende Stege 13a, 13b, 13,c auf, wobei die Wicklung 3a, 3b in den Zwischenräumen 26, 27 dieser Stege 13a, 13b, 13c angeordnet ist ( Figur 3a). Nach dem Aufsetzen des Kunststoffträgerkörpers 1 auf die Leiterplatte 8 wird das Oberteil 14 des Transformatorkerns auf den Kunststoffkörper 1 aufgesetzt. Somit wird nach Anschluß der Bezugsspannung an die Steckeinrichtung 4, 5 die durch den sogenannten Planartransformator transformierte Spannung über die Kontaktstifte 12 auf die Leistungsbauelemente 11 übertragen.

Bei einem besonders kompakten Ausführungsbeispiel kann auch die Ansteuer- und Regelelektronik 25 als Bestandteil auf dem Substrat 9 mit angeordnet sein. Für den Einsatz im Kraftfahrzeug ist eine weitere Steckeinrichtung 28 vorgesehen, über welche diese Elektronik über den CAN-Bus mit anderen Steuergeräten kommuniziert.

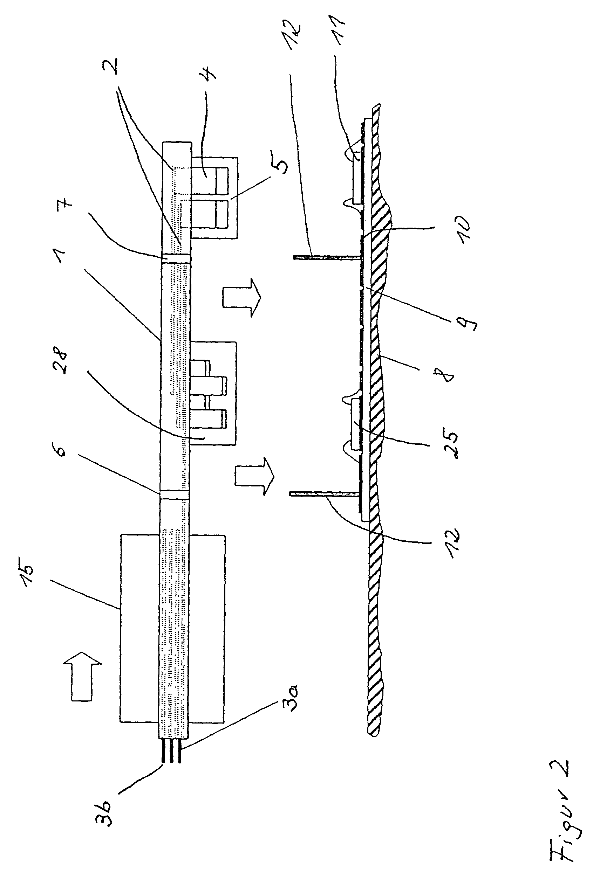

Eine weitere Ausführung der erfindungsgemäßen Anordnung ist in Figur 2 dargestellt. Bei dieser Anordnung ist der Transformatorkern 15 einstückig ausgebildet und weist einen achtähnlichen Querschnitt auf (Figur 3b). Der Transformatorkern 15 wird dabei auf den Kunststoffträgerkörper 1 aufgeschoben und danach wird der so vormontierte Kunststoffträgerkörper 1 auf die Aluminiumplatte 8 aufgesetzt, wobei in der schon beschriebenen Art und Weise die elektrische Verbindung zwischen Kunststoffträgerkörper 1 und der Aluminiumplatte 8 durch die Kontaktstifte 12 realisiert ist.

Durch das Auffliegen des Transformatorkerns 15 auf dem Aluminiumelement 8 ist es möglich, den Transformator mit hohen Leistungen zu betreiben, da durch die Aluminiumplatte 8 eine ausreichende Wärmeabfuhr ermöglicht wird.

Zum Aufschieben des Transformatorkerns 15 sind, wie in Figur 2 dargestellt, die Windungen der Primär- 3a und Sekundärwicklung 3b des Transformators unterbrochen und ragen seitlich unisoliert aus dem Kunststoffträgerkörper 1 heraus. Sie werden durch die Öffnungen 16 und 17 des Transformatorkerns 15 hindurchgeschoben. Anschließend müssen diese Wicklungen elektrisch verbunden werden, um die Funktionsweise des Transformators sicherzustellen. Zu diesem Zweck wird ein in Figur 4 dargestelltes, vorgefertigtes Abschlußteil 18 auf die seitlich hinausragenden Windungen 3a, 3b aufgedrückt. Das Abschlußteil 18 ist ebenfalls ein Kunststoffteil, in welches vorgeformte Stanzblechelemente 29, wie sie auch schon in dem Kunststoffträgerkörper 1 verwendet werden, angeordnet sind. Diese Leiterbahnen 29 führen zu einer elektrischen Verbindung mit den Windungen 3a, 3b einfach nur durch ein kontaktierendes Aufsetzen des Abschlußelementes 18.

Die Windungen können aber auch einfach nur verschweißt oder verlötet und anschließend isoliert werden.

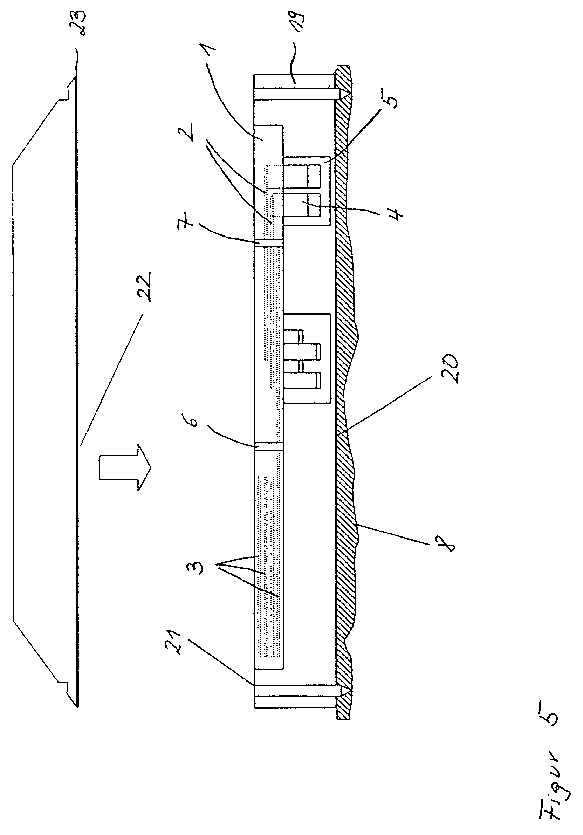

In Figur 5 ist eine fertigungstechnisch besonders günstige Ausgestaltung der erfindungsgemäßen Lösung dargestellt. Ein die Seitenwände eines Gehäuses bildender, an den Kunststoffträgerkörper 1 angeformter Gehäusekragen 19, übernimmt dabei die Gehäusefunktion und wird im Kunststoffspritzvorgang in einem Arbeitsschritt gemeinsam mit dem Steckerkörper 5 und dem Kunststoffträgerkörper 1 gebildet. Zur Befestigung einer Abdeckung 22 sind Schrauben oder Nieten 21 vorgesehen. Um die in diesem Gehäuse 19, 22 angeordnete Elektronik zu schützen, ist an dem Kragen 19 eine Dichtung 20, welche auf der Aluminiumplatte 8 aufliegt, umlaufend angeordnet.
Auch der Rand der Abdeckung 22 trägt eine Dichtung 23, auf welcher der Kunststoffträgerkörper 1 aufliegt. Somit werden mögliche Dichtigkeitsprobleme beim Anschluß an die Grundplatte durch die angespritzte Dichtlippe umgangen.

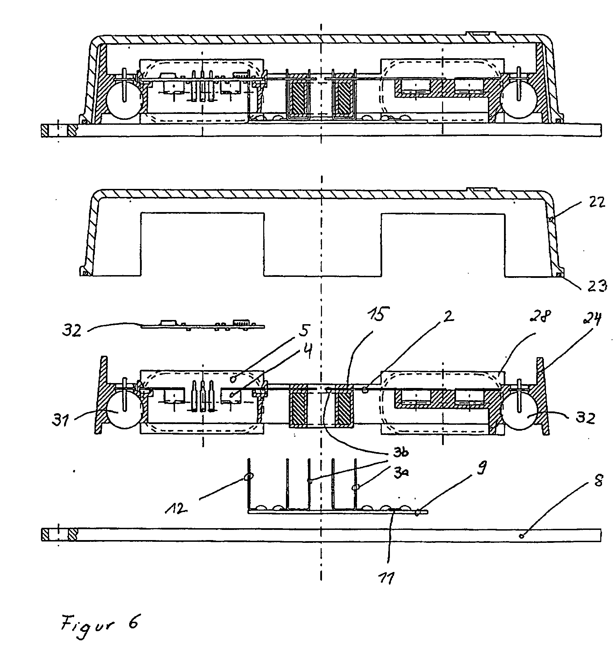

Eine weitere Ausführungsform ist in Figur 6 dargestellt. Dabei ist der Trägerkörper als Gehäusemittelteil 24 ausgebildet. Neben den Steckeinrichtungen 4, 5 bzw. 28 und den Leiterbahnen 2 sind der Transformatorkern 15, ein Kondensator 30 und eine Drossel 31 vom Trägerkörper mit umspritzt. Darüber hinaus ist eine weitere elektronische Komponente 32 in Form einer Bauelemente tragenden Leiterplatte auf das vorgefertigte Gehäusemittelteil aufgesetzt und elektrisch kontaktiert. Die Primär- und Sekundärwicklung 3a, 3b sind durch einzelne Blechformteile 33 gebildet, welche auf der Leiterplatte 9 von dieser wegstehend befestigt und mit den Leistungsbauelementen 11 der Leiterplatte 9 kontaktiert sind. Beim Aufsetzen des Gehäusemittelteiles 24 umschließen diese Belchformteile den Transformatorkern 15 und werden mit den Leiterbahnen 2 unter Bildung von Transformatorwicklungen elektrisch verbunden.

Die gegenüber dem Trägerelement 8 die umlaufende Dichtung 23 aufweisende Abdeckung 22 ist haubenförmig ausgebildet und mit dem Trägerelement 8 verschraubt oder vernietet.

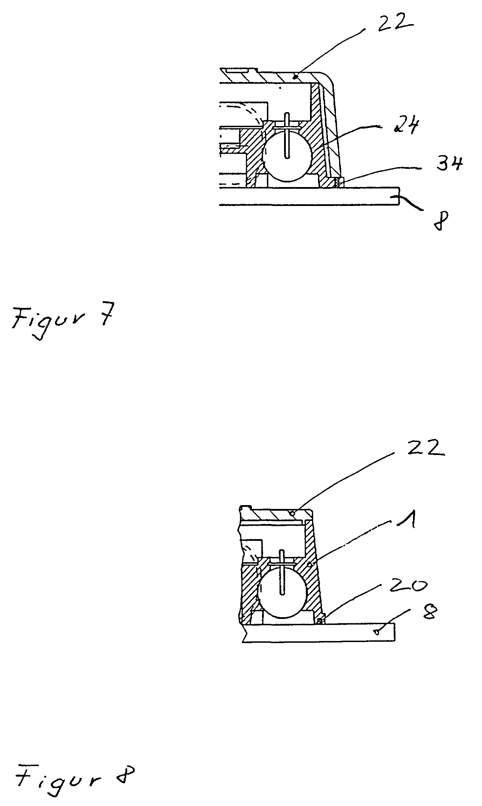

Die Abdeckung 22 kann aber auch auf dem Gehäusemittelteil 24 aufliegen, welches eine angespritzte Dichtung 34 zur Abdeckung 22 und zum Trägerelement 8 aufweist (Figur 7).
In Abwandlung der Vorrichtung gemäß Figur 5 ist die angespritzte Dichtung 20 am Trägerkörper zum Trägerelement 8 hin ausgebildet. Die Abdeckung 22 ist mit dem Trägerkörper 1 in einem Ultraschallschweißverfahren dicht befestigt.(Figur 8)

## Patentansprüche

1. Kompakte elektrische Vorrichtung, insbesondere Schaltnetzteil, mit einem Transformator zur Angleichung verschiedener elektrischer Spannungen zwischen einer elektrischen Schaltung und einer, mit einer Bezugsspannung verbindbaren elektrischen Kontaktiereinrichtung, wobei wenigstens eine Primärwicklung des Transformators mit der Kontaktiereinrichtung und wenigstens eine Sekundärwicklung des Transformators mit der elektrischen Schaltung über erste elektrische Verbindungen verbunden ist, wobei die Primär- und die Sekundärwicklung wenigstens einen Teil eines Transformatorkerns umschließen und die Primärwicklung und die Sekundärwicklung des Transformators und/oder die ersten elektrischen Verbindungen und/oder die Kontaktiereinrichtung in einem aus isolierendem Material bestehenden Trägerkörper angeordnet sind und die ersten elektrischen Verbindungen durch das Material des Trägerkörpers (1) gegeneinander elektrisch isoliert sind, **dadurch gekennzeichnet, dass** der Transformatorkern (13, 14)zweiteilig ausgebildet ist, wobei ein erstes E-ähnliches Kernelement (13)auf dem Trägerelement (8) aufliegt, dessen drei senkrecht vom Trägerelement (8) wegweisende Stege (13a, 13b, 13c) durch entsprechende Transformatoröffnungen des Trägerkörpers (1) greifen und ein zweites, eben oder E-ähnlich ausgebildetes Kernelement (14) die Stege (13a, 13b, 13c) abdeckt und magnetisch miteinander verbindet, wobei die Primär- und die Sekundärwicklung (3a, 3b) umlaufend zwischen den Stegen (13a, 13b, 13c) angeordnet sind und die elektrische Schaltung (11) über eine zweite elektrische Verbindung (12) mit der ersten elektrischen Verbindung (2) des Trägerkörpers (1) verbunden ist.

2. Kompakte elektrische Vorrichtung, insbesondere Schaltnetzteil, mit einem Transformator zur Angleichung verschiedener elektrischer Spannungen zwischen einer elektrischen Schaltung und einer, mit einer Bezugsspannung verbindbaren elektrischen Kontaktiereinrichtung, wobei wenigsten eine Primärwicklung des Transformators mit der Kontaktiereinrichtung und wenigstens eine Sekundärwicklung des Transformators mit der elektrischen Schaltung über erste elektrische Verbindungen verbunden ist, wobei die Primär- und die Sekundärwicklung wenigstens einen Teil eines Transformatorkerns umschließen, und der Transformatorkern und/oder die erste elektrische Verbindung und/oder die Kontaktiereinrichtung in einem aus isolierendem Material bestehenden Trägerkörper angeordnet sind, wobei die ersten elektrischen Verbindungen (2) durch das Material des Trägerkörpers (1) gegeneinander elektrisch isoliert sind **dadurch gekennzeichnet, dass** die Primär- und Sekundärwicklung (3) des Transformators auf dem Trägerkörper (1) so angeordnet sind, dass der Transformatorkern (15) von den Wicklungen (3a, 3b) umschlossen ist und eine zweite elektrische Verbindung (12) mit der ersten elektrischen Verbindung des Trägerkörpers (1) verbunden ist, wobei der Transformatorkern (15) auf einem die elektrische Schaltung (11) tragenden, ebenen Trägerelement (8) aufliegt.

3. Kompakte elektrische Vorrichtung nach Anspruch 1 oder 2, **dadurch gekennzeichnet, dass** zur Bildung der zweiten elektrischen Verbindung mindestens ein Kontaktstift (12) auf einem Trägerelement (8) zur Verbindung der ebenfalls auf dem Trägerelement (8) angeordneten elektrischen Schaltung (11) mit einer der ersten elektrischen Verbindungen (2) des Trägerkörpers (1) angeordnet ist, welche in eine, mit der ersten elektrischen Verbindung (2) elektrisch verbundenen Öffnung (6,7) hineinragt.

4. Kompakte elektrische Vorrichtung nach Anspruch 3, **dadurch gekennzeichnet, dass** der Kontaktstift (12) zur Herstellung der elektrischen Verbindung in die Öffnung (6, 7) des Trägerkörpers (1) eingepresst ist.

5. Kompakte elektrische Vorrichtung nach Anspruch 3, **dadurch gekennzeichnet, dass** die Enden der als Leiterbahn (2) ausgebildeten ersten elektrischen Verbindung aus der Öffnung (6, 7) des Trägerkörpers (1) diesen überragend hinausgeführt sind und der durch die Öffnung (6, 7) geführte Kontaktstift (12) gemeinsam mit den Enden der Leiterbahn (2) verlötet ist.

6. Kompakte elektrische Vorrichtung nach Anspruch 5, **dadurch gekennzeichnet, dass** die Leiterbahnen (2) als Blechformteil ausgebildet sind.

7. Kompakte elektrische Vorrichtung nach Anspruch 6, **dadurch gekennzeichnet, dass** die Blechformteile (2) aus dem Trägerkörper (1) zur Bildung der elektrischen Anschlüsse (4) der Kontaktiereinrichtung (4, 5) herausgeführt sind, wobei der Körper (5) der Kontaktiereinrichtung (4, 5) durch den Trägerkörper (1) gebildet ist.

8. Kompakte elektrische Vorrichtung nach einem der vorhergehenden Ansprüche, **dadurch gekennzeichnet, dass** der Trägerkörper (1) zur nachträglichen Aufnahme von weiteren elektrischen und/oder elektronischen Komponenten (30, 31, 32) ausgebildet ist.

9. Kompakte elektrische Vorrichtung nach Anspruch 8, **dadurch gekennzeichnet, dass** der Trägerkörper (1) eine mit Rasteinrichtungen versehene Aufnahme für eine weitere Komponente (33) aufweist.

10. Kompakte elektrische Vorrichtung nach Anspruch 8, **dadurch gekennzeichnet, dass** außenseitig auf dem Trägerkörper (1) gehäuste oder ungehäuste elektronische Bauelemente (33) angeordnet sind.

11. Kompakte elektrische Vorrichtung nach Anspruch 1, **dadurch gekennzeichnet, dass** der Trägerkörper (1) Bestandteil eines Gehäuses ist, welches das die elektronische Schaltung (11) tragende Trägerelement (8) abdeckt.

12. Kompakte elektrische Vorrichtung nach Anspruch 11,
**dadurch gekennzeichnet, dass** der Trägerkörper (1) einen umlaufenden, abgewinkelten Kragen (19) aufweist, welcher auf dem Trägerelement (8) aufliegt, wobei an den Kragen (19) eine ebenfalls umlaufende Dichtung (20) angespritzt ist.

13. Kompakte elektrische Vorrichtung nach Anspruch 11,
**dadurch gekennzeichnet, dass** der Trägerkörper (1) als Gehäusemittelteil (24) mit einer einseitig angespritzten Dichtung (20) zur Auflage auf dem Trägerelement (8) ausgebildet ist, wobei das Gehäusemittelteil (24) mit einer planen Abdeckung (22) verschlossen ist, die ebenfalls eine angespritzte Dichtung (23) zur Auflage auf dem Gehäusemittelteil (24) aufweist.

14. Kompakte elektrische Vorrichtung nach Anspruch 1 oder 2,
**dadurch gekennzeichnet, dass** das Trägerelement (8) aus Metall, vorzugsweise Aluminium besteht und gleichzeitig zur Wärmeableitung für die Leistungsbauelemente (11) dient.

15. Kompakte elektrische Vorrichtung nach Anspruch 14,
**dadurch gekennzeichnet, dass** das Trägerelement (8) ein Substrat trägt, welches aus auf wärmeleitender Keramik (9) aufgebrachten Kupfer (10) besteht.

16. Kompakte elektrische Vorrichtung nach Anspruch 2, **dadurch gekennzeichnet, dass** die Primär- und Sekundärwicklung (3a, 3b) des Transformators seitlich unterbrochen aus dem Trägerkörper (1) herausragen, wobei der, einen achtähnlichen Querschnitt aufweisende einstückige Transformatorkern (15), über die unterbrochenen Primär- und Sekundärwicklungen (3a, 3b) schiebbar ist, wobei nach Aufschieben des Transformatorkerns (15) die Primär- und Sekundärwicklung (3) mittels eines Trägerkörperabschlussteiles (18), welche den Wicklungen (3) angepasste Leiterbahnen (29) enthält, elektrisch geschlossen werden.

17. Kompakte elektrische Vorrichtung nach Anspruch 15 und 16, **dadurch gekennzeichnet, dass** die flächig ausgebildeten Primär- und Sekundärwicklungen (3a, 3b) des Transformators parallel zum ebenen Trägerelement (8) angeordnet sind.

## Claims

1. Compact electrical device, in particular switched-mode power supply, having a transformer for adjusting different electrical voltages between an electrical circuit and an electrical contacting device which can be connected to a reference voltage, at least one primary winding of the transformer being connected to the contacting device, and at least one secondary winding of the transformer being connected to the electrical circuit via first electrical connections, the primary and secondary windings enclosing at least part of a transformer core, and the primary winding and the secondary winding of the transformer and/or the first electrical connections and/or the contacting device being arranged in a carrier body which is composed of insulating, material, and the first electrical connections being electrically insulated from one another by means of the material of the carrier body (1), **characterized in that** the transformer core (13, 14) is formed in two parts, a first E-like core element (13) resting on the carrier element (8) and its three webs (13a, 13b, 13c) which point away perpendicularly from the carrier element (8) engaging through corresponding transformer openings in the carrier body (1), and a second core element (14) which is of planar or E-like construction covering the webs (13a, 13b, 13c) and connecting them magnetically to one another, the primary winding and the secondary winding (3a, 3b) being arranged so as to run around between the webs (13a, 13b, 13c), and the electrical circuit (11) being connected to the first electrical connection (2) of the carrier body (1) by means of a second electrical connection (12).

2. Compact electrical device, especially switch-mode power supply, comprising a transformer for matching different electrical voltages between an electric circuit and an electrical contacting device which can be connected to a reference voltage, at least one primary winding of the transformer being connected to the contacting device and at least one secondary winding of the transformer being connected to the electrical circuit via first electrical connections, the primary and the secondary windings enclosing at least a part of a transformer core, and the transformer core and/or the first electrical connection and/or the contacting device being arranged in a carrier body consisting of insulating material, the first electrical connections (2) being electrically insulated from one another by the material of the carrier body (1), **characterized in that** the primary and secondary windings (3) of the transformer are arranged on the carrier body (1), in such a manner that the transformer core (15) is enclosed by the windings (3a, 3b) and a second electrical connection (12) being connected to the first electrical connection of the carrier body (1), the transformer core (15) lying on a planar carrier element (8) carrying the electrical circuit (11).

3. Compact electrical device according to Claim 1 or 2, **characterized in that**, for forming the second electrical connection, at least one contact pin (12) is arranged on a carrier element (8) for connecting the electrical circuit (11), which is also arranged on the carrier element (8), to one of the first electrical connections (2) of the carrier body (1) which protrudes into an opening (6, 7) electrically connected to the first electrical connection (2).

4. Compact electrical device according to Claim 3, **characterized in that** the contact pin (12) is pressed into the opening (6, 7) of the carrier body (1) for producing the electrical connection.

5. Compact electrical device according to Claim 3, **characterized in that** the ends of the first electrical connection constructed as conductor track (2) are brought out of the opening (6, 7) of the carrier body (1), protruding beyond the latter, and the contact pin (12) conducted through the opening (6, 7) is soldered together with the ends of the conductor track (2).

6. Compact electrical device according to Claim 5, **characterized in that** the conductor tracks (2) are constructed as shaped sheet-metal part.

7. Compact electrical device according to Claim 6, **characterized in that** the shaped sheet-metal parts (2) are brought out of the carrier body (1) for forming the electrical connections (4) of the contacting device (4, 5), the body (5) of the contacting device (4, 5) being formed by the carrier body (1).

8. Compact electrical device according to one of the preceding claims, **characterized in that** the carrier body (1) is constructed for the later accommodation of further electrical and/or electronic components (30, 31, 32).

9. Compact electrical device according to Claim 8, **characterized in that** the carrier body (1) exhibits a receptacle provided with latching devices for a further component (33).

10. Compact electrical device according to Claim 8, **characterized in that** cased or uncased electronic components (33) are arranged on the outside on the carrier body (1).

11. Compact electrical device according to Claim 1, **characterized in that** the carrier body (1) is a component of a housing which covers the carrier element (8) carrying the electronic circuit (11).

12. Compact electrical device according to Claim 11, **characterized in that** the carrier body (1) exhibits a peripheral angled-away collar (19) which rests on the carrier element (8), a seal (20), which is also peripheral, being integrally moulded to the collar (19) .

13. Compact electrical device according to Claim 11, **characterized in that** the carrier body (1) is constructed as centre part (24) of the housing with a seal (20), which is injection moulded on one side, for resting on the carrier element (8), the centre part (24) of the housing being closed with a planar cover (22) which also has an integrally moulded seal (23) for resting on the centre part (24) of the housing.

14. Compact electrical device according to Claim 1 or 2, **characterized in that** the carrier element (8) consists of metal, preferably aluminium and is used, at the same time, to dissipate heat from the power components (11).

15. Compact electrical device according to Claim 14, **characterized in that** the carrier element (8) carries a substrate which consists of copper (10) applied to thermally conductive ceramics (9).

16. Compact electrical device according to Claim 2, **characterized in that** the primary and secondary windings (3a, 3b) of the transformer protrude from the carrier body (1) in a laterally interrupted manner, the one-piece transformer core (15), which has an eight-like cross section, being pushable over the interrupted primary and secondary windings (3a, 3b), the primary and secondary windings (3), after the transformer core (15) has been pushed on, being electrically closed by means of a carrier body end part (18) which contains conductor tracks (29) adapted to the windings (3).

17. Compact electrical device according to Claims 15 and 16, **characterized in that** the primary and secondary windings (3a, 3b) of the transformer, which are constructed to be flat, are arranged in parallel with the planar carrier element (8).

## Revendications

1. Dispositif électrique compact, notamment, bloc d'alimentation, comportant un transformateur destiné à l'harmonisation de tensions électriques différentes entre un circuit électrique et un dispositif de connexion électrique, qui peut être relié à une tension de référence, au moins un enroulement primaire du transformateur étant relié au dispositif de connexion et au moins un enroulement secondaire du transformateur étant relié au circuit électrique par l'intermédiaire de premières liaisons électriques, l'enroulement primaire et l'enroulement secondaire englobant au moins une partie d'un noyau du transformateur et l'enroulement primaire et l'enroulement secondaire du transformateur et/ou les premières liaisons électriques et/ou le dispositif de connexion étant disposés dans un corps porteur composé d'un matériau isolant et les premières liaisons électriques étant isolées électriquement l'une par rapport à l'autre par le matériau du corps porteur (1) **caractérisé par le fait que** le noyau du transformateur (13, 14) est conçu en deux parties, un premier élément du noyau (13), en forme de E étant appliqué sur l'élément porteur (8), dont les trois entretoises (13a, 13b, 13c), qui hérissent perpendiculairement de l'élément porteur (8), s'introduisent dans des ouvertures du transformateur correspondantes du corps porteur (1), et un deuxième élément d u noyau (14), conçu plan ou en forme de E, recouvrant les entretoises (13a, 13b, 13c) et les reliant magnétiquement les unes aux autres, l'enroulement primaire et l'enroulement secondaire (3a, 3b) étant disposés d'une façon circulaire entre les entretoises (13a, 13b, 13c) et le circuit électrique (11) étant relié, par l'intermédiaire d'une deuxième liaison électrique (12), à la première liaison électrique (2) du corps porteur (1).

2. Dispositif électrique compact, notamment, bloc d'alimentation, comportant un transformateur destiné à l'harmonisation de tensions électriques différentes entre un circuit électrique et un dispositif de connexion électrique, qui peut être relié à une tension de référence, au moins un enroulement primaire du transformateur étant relié au dispositif de connexion et au moins un enroulement secondaire du transformateur étant relié au circuit électrique par l'intermédiaire de premières liaisons électriques, l'enroulement primaire et l'enroulement secondaire englobant au moins une partie d'un noyau du transformateur et le noyau du transformateur et/ou la première liaison électrique et/ou le dispositif de connexion étant disposés dans un corps porteur composé d'un matériau isolant, les premières liaisons électriques (2) étant isolées électriquement l'une par rapport à l'autre par le matériau du corps porteur (1) **caractérisé par le fait que** l'enroulement primaire et l'enroulement secondaire (3) du transformateur est disposé sur le corps porteur (1) de telle sorte que le noyau (15) du transformateur est entouré par les enroulements (3a, 3b) et qu'une deuxième liaison électrique (12) est reliée à la première liaison électrique du corps porteur (1), le noyau (15) du transformateur étant appliqué sur un élément porteur (8), plan et portant le circuit électrique (11).

3. Dispositif électrique compact selon la revendication 1 ou 2 **caractérisé par le fait que**, pour former la deuxième liaison électrique, au moins une broche de contact (12) est disposée sur un élément porteur (8) pour la liaison entre le circuit électrique, disposé également sur l'élément porteur (8), et l'une des premières liaisons électriques (2) du corps porteur (1), laquelle dépasse dans une ouverture (6, 7) reliée électriquement à la première liaison électrique (2).

4. Dispositif électrique compact selon la revendication 3 **caractérisé par le fait que**, pour établir la liaison électrique, la broche de contact (12) est pressée dans l'ouverture (6, 7) du corps porteur (1).

5. Dispositif électrique compact selon la revendication 3 **caractérisé par le fait que** les extrémités de la première liaison électrique conçue comme piste conductrice (2) sont sorties de l'ouverture (6, 7) du corps porteur (1) en le surmontant et que la broche de contact (12) introduite à travers l'ouverture (6, 7) est soudée aux extrémités de la piste conductrice (2).

6. Dispositif électrique compact selon la revendication 5 **caractérisé par le fait que** les pistes conductrices (2) sont formées par des pièces profilées en tôle.

7. Dispositif électrique compact selon la revendication 6 **caractérisé par le fait que** les pièces profilées en tôle (2) sortent du corps porteur (1) pour former les bornes (4) de raccordement électrique du dispositif de connexion (4, 5), le corps (5) du dispositif de connexion (4, 5) étant formé par le corps porteur (1).

8. Dispositif électrique compact selon l'une des revendications précédentes **caractérisé par le fait que** le corps porteur (1) est conçu pour recevoir ultérieurement d'autres composants électriques et/ou électroniques (30, 31, 32).

9. Dispositif électrique compact selon la revendication 8 **caractérisé par le fait que** le corps porteur (1) a un support muni de systèmes d'encliquetage pour un autre constituant (33).

10. Dispositif électrique compact selon la revendication 8 **caractérisé par le fait que** des composants électroniques (33), munis d'un boîtier ou non, sont disposés à l'extérieur sur le corps porteur (1).

11. Dispositif électrique compact selon la revendication 1 **caractérisé par le fait que** le corps porteur (1) fait partie intégrante d'un boîtier qui recouvre l'élément porteur (8) supportant le circuit électronique (11).

12. Dispositif électrique compact selon la revendication 11 **caractérisé par le fait que** le corps porteur (1) a un col (19), circulaire et coudé, qui s'applique sur l'élément porteur (8), un joint (20) également circulaire étant moulé par injection sur le col (19).

13. Dispositif électrique compact selon la revendication 11 **caractérisé par le fait que** le corps porteur (1) est conçu comme pièce centrale (24) du boîtier avec un joint (20) moulé par injection d'un côté et s'appliquant sur l'élément porteur (8), la pièce centrale (24) du boîtier étant fermée par un couvercle plan (22), qui a également un joint (23) moulé par injection s'appliquant sur la pièce centrale (24) du boîtier.

14. Dispositif électrique compact selon la revendication 1 ou 2 **caractérisé par le fait que** l'élément porteur (8) est en métal, d'une façon préférentielle en aluminium, et sert en même temps à dissiper la chaleur des composants de puissance (11).

15. Dispositif électrique compact selon la revendication 14 **caractérisé par le fait que** l'élément porteur (8) supporte un substrat en cuivre (10) métallisé sur une céramique (9) conductrice à la chaleur.

16. Dispositif électrique compact selon la revendication 2 **caractérisé par le fait que** l'enroulement primaire et l'enroulement secondaire (3a, 3b) du transformateur sont interrompus latéralement et dépassent du corps porteur (1), le noyau (15) du transformateur, en une pièce et ayant une section transversale semblable à un huit, pouvant être glissé sur les enroulements primaire et secondaire (3a, 3b) interrompus, l'enroulement primaire et l'enroulement secondaire (3) étant fermés électriquement, une fois que le noyau (15) du transformateur est engagé, par une pièce de terminaison (18) du corps porteur, laquelle renferme des pistes conductrices (29) adaptées aux enroulements (3).

17. Dispositif électrique compact selon la revendication 15 et 16 **caractérisé par le fait que** les enroulements primaire et secondaire (3a, 3b) du transformateur, conçus plans, sont disposés parallèlement à l'élément porteur plan (8).
